# EUROPÄISCHE PATENTANMELDUNG

(11) **EP 1 389 779 A2**
(43) Veröffentlichungstag der Anmeldung: **18.02.2004**
(21) Anmeldenummer: 03018197.8
(22) Anmeldetag: 09.08.2003
(51) Int. Cl.: G11B 27/36, G11B 27/11, G11B 27/28, G11B 19/02, G11B 20/10, G11C 7/16, H04N 5/00, H04N 5/781, H04N 5/76, H04N 7/088, H04N 7/16, H04H 1/00, G11B 27/34

(54) **Gerät für die Aufzeichnung von digitalen Signalen**

(30) Priorität: 16.08.2002 DE 10237624
(71) Anmelder: GRUNDIG Aktiengesellschaft, 90471 Nürnberg (DE)
(72) Erfinder: Horn, Bernhard, 91301 Forchheim (DE)

(57) **Zusammenfassung**

Die vorliegende Erfindung betrifft ein Gerät für die Aufzeichnung und/oder Wiedergabe von digitalen Audio- und/oder Videosignalen und sein Verhalten bei einer Störung während der Aufzeichnung der digitalen Audio- und/oder Videosignale.

Bei einem Gerät für die Aufzeichnung und/oder Wiedergabe von digitalen Audio- und/oder Videosignalen, mit einer ersten Einrichtung für die Verarbeitung von digitalen Audio- und/oder Videosignalen, einer zweiten Einrichtung für die Aufzeichnung und Speicherung der digitalen Audiound/oder Videosignale, und einer Steuereinrichtung für die Steuerung der das Gerät bildenden Einrichtungen, wird dabei davon ausgegangen, dass das Gerät einen nichtflüchtigen Speicher aufweist, dass die Steuereinrichtung bei einer Aufzeichnung von digitalen Audio- und/oder Videosignalen eine die Aufzeichnung kennzeichnende Information erzeugt und in den nichtflüchtigen Speicher schreibt, und dass die Steuereinrichtung die die Aufzeichnung kennzeichnende Information nach Abschluß der Aufzeichnung in dem nichtflüchtigen Speicher löscht.

## Beschreibung

Die vorliegende Erfindung betrifft ein Gerät für die Aufzeichnung und/oder Wiedergabe von digitalen Audio- und/oder Videosignalen.

Bei bekannten Geräten für die Aufzeichnung und/oder Wiedergabe von digitalen Audio- und/oder Videosignalen werden die digitalen Audio- und/oder Videosignale auf ein Speichermedium aufgezeichnet. Die Daten der digitalen Audio- und/oder Videosignale werden dabei entweder fortlaufend in einem bekannten Format auf dem Speichermedium aufgezeichnet, d. h. die Daten - und damit die Audio- und/oder Videosignale - können später ohne weiteres fortlaufend wiedergegeben werden. Bei einer anderen Variante ist es vorgesehen, ein sogenanntes Filesystem einzusetzen, welches aus den Daten einer Aufzeichnung, z. B. einer Sendung, eine Datei formt. Am Ende der Aufzeichnung stellt das Filesystem zudem wichtige Angaben über diese Datei sowie über die Aufzeichnung der Daten auf dem Speichermedium zur Verfügung und stellt sicher, dass diese Angaben mit auf dem Speichermedium aufzeichnet aufgezeichnet werden, da sie für eine spätere Wiedergabe der Datei bzw. digitalen Audio- und/oder Videosignale benötigt werden.

Kommt es während der Aufzeichnung der digitalen Audio- und/oder Videosignale zu einer Unterbrechung des Betriebs des Geräts, z. B. weil die Stromversorgung des Geräts durch einen Fehler im Stromnetz, Blitzschlag, Überlast oder sonstige Störungen, schwankt oder unterbrochen wird, wird die Aufzeichnung abgebrochen und das Gerät schaltet sich - nachdem die Stromversorgung wieder störungsfrei zur Verfügung steht - in einen Bereitschaftszustand.

Somit weisen die bekannten Geräte und Verfahren für die Aufzeichnung und/oder Wiedergabe von digitalen Audio- und/oder Videosignalen den Nachteil auf, dass die Aufzeichnung der digitalen Audio- und oder Videosignale abgebrochen wird, weshalb nur ein Fragment der gewünschten Aufzeichnung auf dem Speichermedium aufgezeichnet wird und für eine spätere Wiedergabe zur Verfügung steht.

Bei der Verwendung eines Filesystems geht die Aufzeichnung, wenn keine entsprechenden Vorkehrungen getroffen sind, sogar völlig verloren, da das Filesystem die Datei der Aufzeichnung nicht ordnungsgemäß abschließen kann, so dass für die Wiedergabe benötigten Angaben über die Aufzeichnung nicht zur Verfügung stehen. Hierzu ist es aus der EP 1 172 817 bekannt, eine das Filemenagement bereffende Information so mit aufzuzeichnen, dass, bei einer Unterbrechung der Aufzeichnung z. B. durch einen Stromausfall, die Datei mit der begonnenen Aufzeichnung wieder auffindbar und auslesbar ist.

Es ist daher Aufgabe der vorliegenden Erfindung, ein Gerät für die Aufzeichnung und/oder Wiedergabe von digitalen Audio- und/oder Videosignalen anzugeben, welches eine möglichst vollständige Aufzeichnung und somit spätere Wiedergabe der Aufzeichnung eines Programmbeitrages erlaubt.

Bei der vorliegenden Erfindung wird diese Aufgabe durch die Merkmale der Ansprüche 1 oder 2 gelöst.

Bei einem Gerät für die Aufzeichnung und/oder Wiedergabe von digitalen Audio- und/oder Videosignalen, mit einer ersten Einrichtung für die Verarbeitung von digitalen Audio- und/oder Videosignalen, einer zweiten Einrichtung für die Aufzeichnung und Speicherung der digitalen Audiound/oder Videosignale, und einer Steuereinrichtung für die Steuerung der das Gerät bildenden Einrichtungen, wird dabei davon ausgegangen, dass das Gerät einen nichtflüchtigen Speicher aufweist, dass die Steuereinrichtung bei einer Aufzeichnung von digitalen Audio- und/oder Videosignalen eine die Aufzeichnung kennzeichnende Information erzeugt und in den nichtflüchtigen Speicher schreibt, wobei die die Aufzeichnung kennzeichnende Information Anfangszeit und/oder Endzeit und/oder Zeitdauer der Aufzeichnung oder eine Sendungskennzeichnung enthält und dass die Steuereinrichtung die die Aufzeichnung kennzeichnende Information nach Abschluß der Aufzeichnung in dem nichtflüchtigen Speicher löscht.

Die vorliegende Erfindung hat somit den Vorteil, dass eine eine Aufzeichnung kennzeichnende Information jedesmal dann erzeugt und gespeichert wird, wenn eine Aufzeichnung vorgenommen wird. Kommt es während der Aufzeichnung zu einer Störung, die zu einer Unterbrechung der Aufzeichnung führt, bleibt die die Aufzeichnung kennzeichnende Information erhalten und kann später - nachdem die Störung beseitigt ist - dazu verwendet werden, die Aufzeichnung fortzusetzen. Wurde die Aufzeichnung dagegen vollständig durchgeführt, wird die die Aufzeichnung kennzeichnende Information gelöscht und der normale Betrieb des Geräts für die Aufzeichnung und/oder Wiedergabe von digitalen Audio- und/oder Videodaten kann fortgesetzt werden.

Weitere Vorteile der vorliegenden Erfindung ergeben sich aus den abhängigen Ansprüchen sowie der nachfolgenden Beschreibung einer erfindungsgemäßen Ausführungsform eines Geräts für die Aufzeichnung und/oder Wiedergabe von digitalen Audio- und/oder Videosignalen anhand von Figuren.

Es zeigt:
- Figur 1: ein Prinzipschaltbild eines Geräts für die Aufzeichnung und/oder Wiedergabe von digitalen Audio- und/oder Videosignalen, und
- Figur 2: ein Prinzipschaltbild einer Stromversorgung für das Gerät nach Figur 1.

Zur Erleichterung des Verständnisses der vorliegenden Erfindung sind in den Figuren nur die Bestandteile dargestellt, die im Zusammenhang mit der Erfindung von Bedeutung sind. Gleichartige Bestandteile in unterschiedlichen Figuren weisen die selben Bezugszeichen auf.

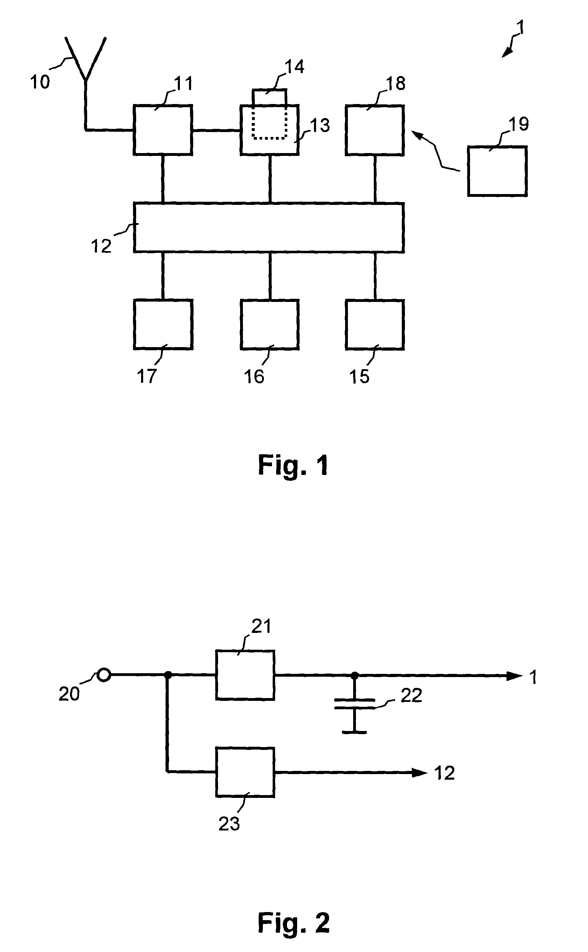

In Figur 1 ist ein Prinzipschaltbild eines Geräts für die Aufzeichnung und/oder Wiedergabe von digitalen Audio- und/oder Videosignalen dargestellt.

Das Gerät 1 weist eine erste Einrichtung 11 für die Verarbeitung von digitalen Audio- und/oder Videosignalen auf, die beispielsweise von einer Antenne 10 empfangene Rundfunk- oder Fernsehsignale auswertet. Die von der ersten Einrichtung 11 erzeugten digitalen Audio- und/oder Videosignale werden an eine zweite Einrichtung 13, 14 für die Aufzeichnung und Speicherung der digitalen Audio- und/oder Videosignale weitergegeben, welche diese aufzeichnet.

Die zweite Einrichtung 13, 14 kann beispielsweise von einer magnetischen Speichereinrichtung, wie einer Festplatte, einer optischen oder magnetooptischen Speichereinrichtung, wie DVD oder CD-ROM, oder einer Festkörperspeichereinrichtung, wie einem Flash-Speicher, gebildet werden. Das Speichermedium 14 der zweiten Einrichtung 13, 14 für die Aufzeichnung und Speicherung der digitalen Audio- und/oder Videosignale kann austauschbar gestaltet sein, so dass mehrere verschiedene Speichermedien 14 in der zweiten Einrichtung 13, 14 verwendet werden können.

Die erste Einrichtung 11 für die Verarbeitung von digitalen Audio- und/oder Videosignalen, bzw. das gesamte Gerät 1, kann von einem Satellitenempfänger gebildet werden. Die erste Einrichtung 11, bzw. das gesamte Gerät 1, kann aber auch von einer Settopbox gebildet werden. Anstelle des Anschlusses an eine Antenne 10 kann auch der Anschluß an ein Kabelnetz oder dergleichen vorgesehen sein, um Rundfunk- und Fernsehsignale beispielsweise nach den Standards DAB oder DVB zu empfangen. Es ist selbstverständlich, dass die Einrichtung 11 auch analoge Rundfunk- und Fernsehsignale sowie analoge Audio- und/oder Videosignale verarbeiten kann, die mittels eines Analog-/Digitalwandlers für die Aufzeichnung durch die zweite Einrichtung 13, 14 in digitale Signale umgesetzt werden. Dabei können zusätzlich bekannte Codierungsverfahren, z. B. MPEG, eingesetzt werden.

Die erste und zweite Einrichtung 11 und 13, 14 werden von einer Steuereinrichtung 12, beispielsweise einem Mikroprozessor, gesteuert. An die Steuereinrichtung 12 sind ein Arbeitsspeicher 15, z. B. ein RAM-Speicher, und ein nichtflüchtiger Speicher 16, z. B. ein EEPROM- oder ein Flash-Speicher, angeschlossen.

Die Steuereinrichtung 12 steuert die Funktion des Geräts 1 mittels Software, die z. B. im nichtflüchtigen Speicher 16 gespeichert ist. Dazu wird der jeweils benötigte Teil der Software von der Steuereinrichtung 12 in den Arbeitsspeicher 15 geladen und ausgeführt. Auf den Arbeitsspeicher 15 kann aber auch verzichtet werden, dann wird die Software direkt aus dem nichtflüchtigen Speicher 16 heraus von der Steuereinrichtung 12 ausgeführt.

Zur Bedienung des Geräts 1 ist eine Bedieneinrichtung 18, 19 vorgesehen, z. B. bestehend aus einem Fernbedienungsgeber 19 und einem Fernbedienungsempfänger 18. Mittels des Fernbedienungsgebers 19 kann ein Bediener beispielsweise festlegen, dass digitale Audio- und/oder Videosignale aufgezeichnet werden. Dazu kann der Bediener beispielsweise eine Anfangszeit für den Beginn der Aufzeichnung und eine Endzeit für das Ende der Aufzeichnung und/oder eine Zeitdauer für die Aufzeichnung mittels des Fernbedienungsgebers 19 festlegen. Ebenso kann der Bediener einen bestimmten Sender auswählen, dessen Signale aufgezeichnet werden sollen. Wahlweise oder zusätzlich kann eine Sendungskennzeichnung, welche beispielsweise eine Sendung kennzeichnet, die aufgezeichnet werden soll, für die Festlegung einer Aufzeichnung verwendet werden. Diese Angaben können auch aus einer sogenannten elektronischen Programmzeitschrift (EPG), die z. B. in den Signalen digitaler Fernsehsignale enthalten ist, ausgewählt und übernommen werden. Werden analoge Rundfunk- oder Fernsehsignale empfangen, können entsprechende Angaben beispielsweise aus dem Videotext oder VPS-Signalen gewonnen werden. Zu der festgelegten Anfangszeit wird dann, unter Steuerung der Steuereinrichtung 12, bis zur Endzeit oder für die festgelegte Zeitdauer, die eventuell über die Sendungskennzeichnung ausgewählte Sendung von der zweiten Einrichtung 13, 14 für die Aufzeichnung von digitalen Audio- und/oder Videodaten aufgezeichnet.

Zu Beginn der Aufzeichnung erzeugt die Steuereinrichtung 12 eine die Aufzeichnung kennzeichnende Information, die im nichtflüchtigen Speicher 16 gespeichert wird. Die die Aufzeichnung kennzeichnende Information kann im einfachsten Fall ein Statusbit sein, das gesetzt wird, sobald die Aufzeichnung beginnt. Die die Aufzeichnung kennzeichnende Information kann aber auch weitere Angaben über die Aufzeichnung enthalten, wie z. B. die Anfangszeit, die Endzeit, die Zeitdauer der Aufzeichnung, den aufzuzeichnenden Sender, die Sendungskennzeichnung der aufzuzeichnenden Sendung usw. Wird die Aufzeichnung ordnungsgemäß und vollständig vorgenommen, wird die die Aufzeichnung kennzeichnende Information von der Steuereinrichtung 12 aus dem nichtflüchtigen Speicher 16 entfernt, d. h. gelöscht, und das Gerät 1 beispielsweise in einen Bereitschaftszustand versetzt.

Kommt es während der Aufzeichnung zu einer Unterbrechung der Aufzeichnung, z. B. weil das Gerät 1 wegen einer Störung oder Unterbrechung der Stromversorgung ausfällt, wird bei einer erneuten Inbetriebnahme des Geräts 1 oder generell bei jeder Inbetriebnahme, z. B. nachdem die Stromversorgung wieder zur Verfügung steht, von der Steuereinrichtung 12 überprüft, ob die die Aufzeichnung kennzeichnende Information, z. B. das Statusbit, im nichtflüchtigen Speicher 16 gespeichert ist. Wird die die Aufzeichnung kennzeichnende Information nicht gefunden, wird das Gerät 1 von der Steuereinrichtung 12 in einen Bereitschaftszustand gebracht, z. B. in einen Stand-by-Betrieb. Wird jedoch die die Aufzeichnung kennzeichnende Information im nichtflüchtigen Speicher 16 gefunden, startet die Steuereinrichtung 12 die Aufzeichnung der digitalen Audio- und/oder Videosignale der ersten Einrichtung 11 durch die zweite Einrichtung 13, 14 für die Aufzeichnung der digitalen Audio- und/oder Videosignale.

Die vom Bediener ausgewählte Aufzeichnung wird dann bis zum Ende der Aufzeichnung, z. B. dem Ende einer ausgewählten Sendung, fortgesetzt. Ist die Aufzeichnung beendet, wird - wie oben beschrieben - die die Aufzeichnung kennzeichnende Information gelöscht und das Gerät 1 in einen Bereitschaftszustand versetzt. Die Aufzeichung kann dann mittels des Geräts 1 wiedergegeben werden und steht dazu bis auf die durch die Störung verursachte Unterbrechung zur Verfügung.

Zur Kennzeichnung einer Unterbrechung in der Aufzeichnung kann es vorgesehen sein, dass von der Steuereinrichtung 12 ein Hinweis erzeugt wird, der beispielsweise auf das Vorliegen einer Unterbrechung und die Zeitdauer der Unterbrechung hinweist. Der Hinweis wird zusammen mit den aufzuzeichnenden Audio- und/oder Videodaten von der zweiten Einrichtung 13, 14 aufgezeichnet. Bei der Wiedergabe der Aufzeichnung wird dieser Hinweis von der Steuereinrichtung 12 beispielsweise auf einer Anzeige dargestellt oder für eine bestimmte Zeitdauer in ein wiedergegebenes Videosignal eingeblendet.

Alternativ oder zusätzlich kann es vorgesehen sein, das wiedergegebene Audio- und/oder Videosignal an der Stelle der Unterbrechung zu verändern, um die Unterbrechung kenntlich zu machen. Beispielsweise kann dazu ein Videosignal aus- und wieder eingeblendet werden oder es kann eine zerbröselnde, blockartige Darstellung gewählt werden. Ebenso kann das Audiosignal aus- und wieder eingeblendet werden.

Der erneute Start der Aufzeichnung durch die Steuereinrichtung 12 kann auch in Abhängigkeit von den in der eine Aufzeichnung kennzeichnenden Information enthaltenen zusätzlichen Angaben erfolgen. In diesem Fall überprüft die Steuereinrichtung 12 ob der Zeitpunkt der erneuten Inbetriebnahme innerhalb von Anfangs- und Endzeit bzw. der Zeitdauer für die Aufzeichnung liegt. Dazu kann die Steuereinrichtung 12 mit einer Echtzeituhr 17 verbunden sein, welche zur Bestimmung des Zeitpunkts der erneuten Inbetriebnahme dient. Der Zeitpunkt der erneuten Inbetriebnahme kann aber von der Steuereinrichtung 12 auch beispielsweise aus einer Zeitinformation abgeleitet werden, die in den digitalen Audio- und/oder Videosignalen bzw. den Rundfunk- oder Fernsehsignalen enthalten ist.

Zusätzlich oder alternativ kann bei einer Inbetriebnahme, bei der von der Steuereinrichtung 12 die die Aufzeichnung kennzeichnende Information im nichtflüchtigen Speicher 16 vorgefunden wird, vor einem erneuten Start der Aufzeichnung auch überprüft werden, ob die für die Aufzeichnung bestimmte Sendung noch gesendet wird. Dazu werden von der Steuereinrichtung 12 die durch die erste Einrichtung 11 empfangenen Signale ausgewertet, ob die im nichtflüchtigen Speicher 16 gespeicherte Sendungskennzeichnung mit der durch die erste Einrichtung 11 empfangenen Sendungskennzeichnung übereinstimmt.
Für den Fall, dass für die Aufzeichnung der digitalen Audio- und/oder Videosignale ein sogenanntes Filesystem verwendet wird, wobei durch das Filesystem eine Datei für eine Aufzeichnung gebildet wird, die neben den digitalen Audio- und/oder Videodaten wichtige Angaben über diese Datei sowie über die Aufzeichnung der digitalen Audio- und/oder Videosignale auf dem Speichermedium enthält, die für eine spätere Wiedergabe der Datei bzw. digitalen Audio- und/oder Videosignale benötigt werden, werden die wichtigen Angaben des Filesystems von der Steuereinheit 12 mit der die Aufzeichnung kennzeichnenden Information im nichtflüchtigen Speicher 16 gespeichert. Die wichtigen Angaben des Filesystems können z. B. Angaben über den aktuellen Sektor des Speichermediums 13, den Status des Sektors usw. enthalten. Weiterhin können die wichtigen Angaben Auskunft über einzelne Aufzeichnungsbestandteile wie Bildanfang und Audioframeanfang enthalten. Wird von der Steuereinrichtung 12 die Notwendigkeit der Fortsetzung einer Aufzeichnung erkannt, werden die im nichtflüchtigen Speicher 16 gespeicherten wichtigen Angeben des Filesystems von der Steuereinrichtung 12 dazu verwendet, die von dem Filesystem erzeugte Datei fortzusetzen und nach vollständiger Aufzeichnung abzuschließen, so dass die in der Datei aufgezeichneten Audio- und/oder Videodaten zu einem späteren Zeitpunkt wiedergegeben werden können.

Die zusätzliche Speicherung der wichtigen Angaben des Filesystems bietet den bereits erwähnten Vorteil, dass die vom Filesystem gebildete Datei auch nach einer Unterbrechung der Aufzeichnung noch brauchbar ist, d. h. wiedergegeben werden kann. Zudem erlauben die Angaben über Bildanfang und Audioframeanfang eine störungsfreie Wiedergabe, d. h. eine Wiedergabe ohne eine Zersplitterung des Bildes bzw. ohne Knackgeräusche des Tons.

In einer Abwandlung des Filesystems kann es vorgesehen sein, dass das Filesystem die Aufzeichnung in kurze Aufzeichnungsblöcke unterteilt und für jeden Aufzeichnungsblock eine eigene Datei erstellt, wobei die einzelnen Dateien als zusammengehörig gekennzeichnet werden, um eine spätere Wiedergabe der aus den einzelnen Dateien bestehenden Aufzeichnung zu ermöglichen. Jede Datei wird dabei vom Filesystem vollständig abgeschlossen, d. h. mit den oben beschriebenen wichtigen Angaben versehen. Die Aufzeichnungsblöcke können beispielsweise jeweils eine Länge von einer Minute oder weniger aufweisen. Bei einer Unterbrechung der Aufzeichnung ist es somit möglich nur den bei der Unterbrechung gerade bearbeiteten Aufzeichnungsblock bzw. dessen Datei zu verwerfen, so dass nur eine Unterbrechung der Aufzeichnung von maximal der Länge eines Aufzeichnungsblocks entsteht, falls es sich um eine kurze Störung handelt.

In Figur 2 ist ein Prinzipschaltbild einer Stromversorgung für das Gerät 1 dargestellt. Die Stromversorgung ist an eine Netzspannung 20 angeschlossen und wird von einer dritten Einrichtung 21, 23 gebildet. Die dritte Einrichtung 22, 23 enthält beispielsweise einen Spannungswandler und Gleichrichter 21, der die für das Gerät 1 erforderliche Stromversorgung bereit stellt. Außerdem enthält die dritte Einrichtung 21, 23 einen Detektor 23, der die Netzspannung 20 auf Schwankungen und/oder Ausfälle untersucht. Stellt der Detektor 23 aufgrund einer Schwankung und/oder eines Ausfalls der Netzspannung 20 eine Störung und/oder Unterbrechung der Stromversorgung des Geräts 1 fest, erzeugt der Detektor 23 ein entsprechendes Steuersignal, welches er an die mit ihm verbundene Steuereinrichtung 12 weiterleitet. Auf das Steuersignal des Detektors 23 hin, schreibt die Steuereinrichtung 12 die die Aufzeichnung kennzeichnende Information bzw. die oben beschriebenen, die Aufzeichnung kennzeichnenden Angaben, in den nichtflüchtigen Speicher 16. Um den Schreibvorgang sicher durchführen zu können, ist ein Energiespeicher 22, z. B. ein Kondensator, vorgesehen, der die Stromversorgung für das Gerät 1, oder wenigstens die Steuereinrichtung 12 und den nichtflüchtigen Speicher 16, zumindest für die Zeitdauer des Schreibvorgangs der die Aufzeichnung kennzeichnenden Information bzw. der die Aufzeichnung kennzeichnenden Angaben durch die Steuereinrichtung 12 in den nichtflüchtigen Speicher 16 aufrecht erhält.

In einer Weiterbildung kann es vorgesehen sein, dass eine unvollständige Aufzeichnung vervollständigt wird. Dazu analysiert die Steuereinrichtung 12 von der ersten Einrichtung 11 stammende Programmdaten nach der Sendungskennzeichnung der die Aufzeichnung kennzeichnenden Information, ob die entsprechende Sendung zu einem späteren Zeitpunkt nochmals gesendet wird. Die Programmdaten können beispielsweise von der oben erwähnten elektronischen Programmzeitschrift oder von Videotextseiten gebildet werden.

Findet die Steuereinrichtung 12 in den Programmdaten die Sendungskennzeichnung der die Aufzeichnung kennzeichnenden Information zu einem späteren Zeitpunkt, entnimmt sie den Programmdaten die für eine Aufzeichnung notwendigen Angaben wie Sendezeitpunkt und Sender der gewünschten Sendung. Mit den entnommenen Angaben wird die Aufzeichnung der Sendung von der Steuereinrichtung 12 gesteuert, um die Sendung, d. h. die Audio- und/oder Videosignale, zu vervollständigen. Dabei kann es vorgesehen sein, die Sendung nochmals vollständig aufzuzeichnen. Es kann aber auch vorgesehen sein, nur den durch die Störung verloren gegangen Teil der Sendung aufzuzeichnen.

## Patentansprüche

1. Gerät für die Aufzeichnung und/oder Wiedergabe von digitalen Audiound/oder Videosignalen, mit
- einer ersten Einrichtung (11) für die Verarbeitung von digitalen Audio- und/oder Videosignalen,
- einer zweiten Einrichtung (13, 14) für die Aufzeichnung und Speicherung der digitalen Audio- und/oder Videosignale,
- einer Steuereinrichtung (12) für die Steuerung der das Gerät bildenden Einrichtungen (11, 13, 14) und einem nichtflüchtigen Speicher (16),
wobei
- die Steuereinrichtung (12) bei einer Aufzeichnung von digitalen Audio- und/oder Videosignalen eine die Aufzeichnung kennzeichnende Information erzeugt und in den nichtflüchtigen Speicher (16) schreibt, und dass die Steuereinrichtung (12) die die Aufzeichnung kennzeichnende Information nach Abschluss der Aufzeichnung in dem nichtflüchtigen Speicher (16) löscht,
- die Steuereinrichtung (12) bei einer Inbetriebnahme des Geräts den nichtflüchtigen Speicher (16) auf das Vorhandensein der die Aufzeichnung kennzeichnenden Information überprüft,
- die Steuereinrichtung (12) die Einrichtungen (11, 13, 14) zur Fortsetzung der Aufzeichnung ansteuert, falls sie die die Aufzeichnung kennzeichnende Information vorfindet,
- die die Aufzeichnung kennzeichnende Information Anfangszeit und/oder Endzeit und/oder Zeitdauer der Aufzeichnung enthält,
- die Steuereinrichtung (12) vor einer Fortsetzung der Aufzeichnung überprüft, ob sich der Zeitpunkt der Fortsetzung der Aufzeichnung innerhalb von Anfangszeit und Endzeit oder Zeitdauer der Aufzeichnung befindet.

2. Gerät für die Aufzeichnung und/oder Wiedergabe von digitalen Audiound/oder Videosignalen, mit
- einer ersten Einrichtung (11) für die Verarbeitung von digitalen Audiound/oder Videosignalen,
- einer zweiten Einrichtung (13, 14) für die Aufzeichnung und Speicherung der digitalen Audio- und/oder Videosignale,
- einer Steuereinrichtung (12) für die Steuerung der das Gerät bildenden Einrichtungen (11, 13, 14) und
- einem nichtflüchtigen Speicher (16),
wobei
- die Steuereinrichtung (12) bei einer Aufzeichnung von digitalen Audio- und/oder Videosignalen eine die Aufzeichnung kennzeichnende Information erzeugt und in den nichtflüchtigen Speicher (16) schreibt, und dass die Steuereinrichtung (12) die die Aufzeichnung kennzeichnende Information nach Abschluss der Aufzeichnung in dem nichtflüchtigen Speicher (16) löscht,
- die Steuereinrichtung (12) bei einer Inbetriebnahme des Geräts den nichtflüchtigen Speicher (16) auf das Vorhandensein der die Aufzeichnung kennzeichnenden Information überprüft,
- die Steuereinrichtung (12) die Einrichtungen (11, 13, 14) zur Fortsetzung der Aufzeichnung ansteuert, falls sie die die Aufzeichnung kennzeichnende Information vorfindet,
- die die Aufzeichnung kennzeichnende Information eine Sendungskennzeichnung enthält,
- Steuereinrichtung (12) vor einer Fortsetzung der Aufzeichnung von der ersten Einrichtung (11) für die Verarbeitung von digitalen Audio- und/oder Videosignalen stammende Sendungskennzeichnungen auf Übereinstimmung mit der Sendungskennzeichnung der die Aufzeichnung kennzeichnenden Information überprüft.

3. Gerät nach Anspruch 1,
**dadurch gekennzeichnet, dass**
das Gerät eine Echtzeituhr (17) enthält, die mit der Steuereinrichtung (12) verbunden ist.

4. Gerät nach Anspruch 1,
**dadurch gekennzeichnet, dass**
die erste Einrichtung (11) für die Verarbeitung von digitalen Audio- und/oder Videosignalen eine Zeitinformation aus den digitalen Audio- und/oder Videosignalen gewinnt und der Steuereinrichtung (12) zur Verfügung stellt.

5. Gerät nach einem der Ansprüche 1 bis 4,
**dadurch gekennzeichnet, dass**
die die Aufzeichnung kennzeichnende Information Angaben über die Aufzeichnung durch die zweite Einrichtung (13, 14) enthält, insbesondere Angaben über aktuellen Sektor, Status des Sektors, Bildanfang, Audioframeanfang usw., und dass die Steuereinrichtung (12) die Angaben über die Aufzeichnung bei einer Fortsetzung der Aufzeichnung berücksichtigt um die zweite Einrichtung (13, 14) anzusteuern.

6. Gerät nach einem der Ansprüche 1 bis 5,
**dadurch gekennzeichnet, dass**
die Steuereinrichtung (12) die Aufzeichnung in Aufzeichnungsblöcke unterteilt und Angaben über den jeweiligen Aufzeichnungsblock der die Aufzeichnung kennzeichnenden Information hinzufügt.

7. Gerät nach einem der Ansprüche 1 bis 6,
**dadurch gekennzeichnet, dass**
das Gerät eine dritte Einrichtung (22, 23) aufweist, mit einem Detektor (23) für die Ermittlung der Störung einer Stromversorgung des Geräts, die mit der Steuereinrichtung (12) verbunden ist, um dieser Störungen der Stromversorgung anzuzeigen, und einem Energiespeicher (22), der während einer Störung der Stromversorgung die Stromversorgung zumindest so lange aufrecht erhält, bis die Steuereinrichtung (12) die die Aufzeichnung kennzeichnende Information bzw. die Angaben über die Aufzeichnung in den nichtflüchtigen Speicher (16) geschrieben hat.

8. Gerät nach einem der Ansprüche 1 bis 7,
**dadurch gekennzeichnet, dass**
die Steuereinrichtung (12) bei einer Inbetriebnahme des Geräts den nichtflüchtigen Speicher (16) auf das Vorhandensein der die Aufzeichnung kennzeichnenden Information überprüft, und dass die Steuereinrichtung (12) das Gerät in einen Bereitschaftszustand bringt, falls sie die die Aufzeichnung kennzeichnende Information nicht vorfindet oder falls die Überprüfung der Anfangszeit, Endzeit, Zeitdauer und/oder der Sendungskennzeichnung keine Übereinstimmung ergibt.

9. Gerät nach einem der Ansprüche 1 bis 8,
**dadurch gekennzeichnet, dass**
die Steuereinrichtung (12) einen Hinweis auf eine Unterbrechung der Aufzeichnung und/oder auf die Zeitdauer der Unterbrechung der Aufzeichnung erzeugt, der von der zweiten Einrichtung (13, 14) aufgezeichnet wird und/oder der Hinweis auf eine Unterbrechung der Aufzeichnung bei der Wiedergabe der Aufzeichnung zum Zeitpunkt der Unterbrechung wiedergegeben wird.

10. Gerät nach einem der Ansprüche 1 bis 9,
**dadurch gekennzeichnet, dass**
das Audio- und/oder Videosignal bei der Wiedergabe zum Zeitpunkt der Unterbrechung verändert wiedergegeben wird.

11. Gerät nach einem der Ansprüche 2 bis 10,
**dadurch gekennzeichnet, dass**
die Steuereinrichtung (12) von der ersten Einrichtung (11) für die Verarbeitung von digitalen Audio- und/oder Videosignalen stammende Programmdaten nach der Sendungskennzeichnung der die Aufzeichnung kennzeichnenden Information durchsucht, und bei Auffinden der Sendungskennzeichnung die Aufzeichnung mittels der Angaben der Programmdaten startet und/oder die Steuereinrichtung (12) die zweite Einrichtung (13, 14) für eine vollständige Aufzeichnung der digitalen Audiound/oder Videodaten startet oder die Steuereinrichtung (12) die zweite Einrichtung (13, 14) für eine Aufzeichnung der digitalen Audio- und/oder Videodaten startet, die während der Unterbrechung nicht aufgezeichnet werden konnten.

12. Gerät nach einem der Ansprüche 1 bis 11,
**dadurch gekennzeichnet, dass**
die zweite Einrichtung (13, 14) für die Aufzeichnung und Speicherung der digitalen Audio- und/oder Videosignale von einer magnetischen Speichereinrichtung gebildet wird.

13. Gerät nach einem der Ansprüche 1 bis 11,
**dadurch gekennzeichnet, dass**
die zweite Einrichtung (13, 14) für die Aufzeichnung und Speicherung der digitalen Audio- und/oder Videosignale von einer optischen oder magnetooptischen Speichereinrichtung gebildet wird.

14. Gerät nach einem der Ansprüche 1 bis 11,
**dadurch gekennzeichnet, dass**
die zweite Einrichtung (13, 14) für die Aufzeichnung und Speicherung der digitalen Audio- und/oder Videosignale von einer Festkörperspeichereinrichtung gebildet wird.

15. Gerät nach einem der Ansprüche 12 bis 14,
**dadurch gekennzeichnet, dass**
die zweite Einrichtung (13, 14) für die Aufzeichnung und Speicherung der digitalen Audio- und/oder Videosignale ein austauschbares Speichermedium (14) aufweist.

16. Gerät nach einem der Ansprüche 1 bis 15,
**dadurch gekennzeichnet, dass**
das Gerät von einem Satellitenreceiver oder einer Settopbox gebildet wird.
